# EUROPÄISCHE PATENTANMELDUNG

(11) **EP 0 585 703 A2**
(43) Veröffentlichungstag der Anmeldung: **09.03.1994**
(21) Anmeldenummer: 93113061.1
(22) Anmeldetag: 14.08.1993
(51) Int. Cl.: G01R 31/34

(54) **Verfahren und Einrichtung zur Messung elektrischer Grössen, insbesondere des Stroms, an einem frequenzumformergesteuerten Elektromotor**

(30) Priorität: 31.08.1992 DE 4228973
(71) Anmelder: GRUNDFOS A/S, DK-8850 Bjerringbro (DK)
(72) Erfinder: Jensen, Niels Due, DK-8850 Bjerringbro (DK); Sokoler, Roman, DK-8870 Langa (DK); Vadstrup, Pierre, DK-8381 Mundelstrup (DK)
(74) Vertreter: Wilcken, Thomas, Dipl.-Ing.

(57) **Zusammenfassung**

Die Strommessung erfolgt an einem frequenzumformergesteuerten Asynchronmotor (2), innerhalb des Leistungsteils des Frequenzumformers (1), und zwar innerhalb eines stromführenden Umrichterzweiges (7) des Wechselrichters (6) dieses Frequenzumformers. Hieraus wird dann der momentane Motorstrom ermittelt. Die Information, wann er jeweilige Zweig stromführend ist, wird dem Regelkreis des Frequenzumrichters entnommen.

## Beschreibung

Die Erfindung betrifft ein Verfahren zur Messung maschineninterner elektrischer Größen, insbesondere des Stroms, an einem frequenzumformergesteuerten Elektromotor sowie eine entsprechende Meßeinrichtung an einem solchen frequenzumformergesteuerten Motor.

Sowohl zur Überprüfung der exakten Steuerung eines Elektromotors als auch insbesondere zur Regelung eines solchen Motors ist es häufig erforderlich, den oder die Phasenströme oder auch den cos φ zu bestimmen. In einfachster Form erfolgt die Strommessung beispielsweise dadurch, daß in jeder Phase eine Strommessung erfolgt, in der Regel mittels eines definierten Widerstandes, an dem ein Spannungsabfall gemessen und so indirekt auf den Stromfluß rückgeschlossen wird.

Eine solche direkte Messung innerhalb der Phase ist nicht nur meßtechnisch aufwendig, sondern bringt auch sicherheitstechnisch eine besondere Problemstellung mit sich, denn die Meßleitungen, Geräte etc. führen die selbe Spannung wie die Motorwicklung, also in der Regel eine vergleichsweise hohe Spannung, die dem menschlichen Körper gefährlich worden kann und somit besondere Sicherheitsanforderungen hinsichtlich Isolierung und Abdichtung mit sich bringt. Zwar ist dieses Problem technisch ohne weiteres beherrschbar, doch bedingt die aufwendige Isolierung erhebliche Fertigungsmehrkosten, die in der Praxis häufig dazu führen, daß bei Motoren der Massenherstellung auf eine solche Phasenstrommessung verzichtet wird.

Im Zuge der Miniaturisierung und Verbilligung auch im Bereich der Leistungselektronik worden Elektromotoren heutzutage mehr und mehr durch vorgeschaltete Frequenzumformer angesteuert, mit denen auf elektronischem Wege die Frequenz und Spannung, mit der der Motor beaufschlagt wird, veränderbar ist, so daß auf diese Weise eine Drehzahlsteuerung des Asynchronmotors möglich ist.

Ausgehend von diesem Stand der Technik stellt sich der Erfindung die Aufgabe, ein unter Ausnutzung des ohnehin vorhandenen Frequenzumformers vereinfachtes Verfahren zur Messung elektrischer Größen des Motors, insbesondere des Stroms und des cos φ zu schaffen, das in der Praxis vergleichsweise kostengünstig verwirklicht werden kann. Des weiteren soll eine Einrichtung für eine solche Messung geschaffen werden.

Der verfahrensmäßige Teil der obigen Aufgabe wird gemäß der Erfindung dadurch gelöst, daß die Messung nicht mehr wie nach dem Stand der Technik in der Versorgungsleitung zum Motor selbst, sondern innerhalb eines stromführenden Umrichterzweiges des Wechselrichters des Frequenzumformers erfolgt, und zwar in der Regel diskontinuierlich, d.h. nicht ständig, sondern nur dann, wenn dieser Zweig in der Tat Strom führt, und daß dann hieraus der momentane Motorstrom oder andere elektrische Größen des Motors, wie beispielsweise des cos φ , ermittelt wird.

Der vorrichtungsmäßige Teil dieser Aufgabe wird dadurch gelöst, daß in den Frequenzumformer ein Meßwiderstand integriert ist, und zwar innerhalb eines Umrichterzweigs des Wechselrichters des Frequenzumformers, an dem dann durch Messung des Spannungsabfalls der Stromfluß oder andere elektrische Größen ermittelt werden kann.

Durch die erfindungsgemäße Lösung kann die Spannungsmessung direkt innerhalb des Frequenzumformers erfolgen, wobei es je nach Anordnung des Meßwiderstandes möglich ist, daß auf der Niederspannungsseite des Wechselrichters gemessen wird, wo ein wesentlich geringeres Spannungspotential als an der Motorwicklung anliegt und somit wesentlich geringere Anforderungen an die Schutzisolierung gestellt sind.

Die Messung jeweils nur in der stromführenden Leitung ermöglicht es erst, an dieser Stelle des Wechselrichters mit der gleichen Zahl von Strommeßeinrichtungen auszukommen, wie bei einer vergleichbaren externen Messung. Die Information, wann der jeweilige Zweig des Frequenzumrichters stromführend ist, steht durch den Frequenzumrichter selbst, insbesondere den Regelkreis zur Verfügung, der die Schalter des Wechselrichters steuert. So genügt bei einem Einphasenasynchronmotor die Strommessung an einem der beiden Wechselrichterzweige. Bei einem Dreiphasenasynchronmotor genügt eine Strommessung in drei der insgesamt sechs Umrichterzweige, wobei die Meßwiderstände auf der selben Seite der paarweise vorgesehenen Umrichterzweige liegen sollten. Bevorzugt liegen die Meßwiderstände dabei auf der Niederspannungsseite, also auf der Seite in den zu den Schaltern des Wechselrichters führenden Leitungen des Leistungsteils, die gegenüber dem Nullpotential ein geringeres Spannungspotential aufweisen, als die auf der anderen Seite des Wechselrichters. Sofern es erforderlich sein sollte, können die Meßwiderstände auch auf der anderen Seite liegen.

Während bei einem Einphasenasynchronmotor für die Strommessung lediglich der Strom eines Zweiges des Wechselrichters zu messen ist und der Strom im anderen Zweig rechnerisch ergänzt werden kann, stellt sich beim Dreiphasenasynchronmotor eine weitere Problematik dahingehend, daß für die Eindeutigkeit der Messung mindestens zwei stromführende Zweige unterschiedlicher Phasen gleichzeitig gemessen werden müssen, um so den dritten Zweig rechnerisch ermitteln zu können. Erst dann können die Phasenströme des Motors exakt ermittelt werden. Auch hier hilft der Regelkreis des Frequenzumrichters, dem diese Daten zur Verfügung stehen. Sofern eine exakte Erfassung des Stromverlaufs nicht erforderlich ist, sondern lediglich eine Durchschnittsmessung, beispielsweise eine RMS-Messung (Rude Mean Square), genügt es, wenn beim Dreiphasenasynchronmotor in einer Halbwelle einer Phase gemessen wird und durch periodische Messung, Interpolation und Estimation ein mittlerer Strom ermittelt wird. In der Regel wird die RMS-Messung den Genauigkeitsanforderungen genügen.

Die Erfindung ist anwendbar bei Motoren mit pulsbreiten- und pulsamplitudenmodulierten Frequenzumformern. Sie wird nachfolgend anhand von zeichnerisch dargestellten Ausführungsbeispielen näher erläutert. Es zeigen:
- Figur 1: in stark vereinfachter Form ein Schaltbild eines frequenzumformergesteuerten Dreiphasenasynchronmotors der zur Durchführung des erfindungsgemäßen Verfahrens ausgebildet ist,
- Figur 2a: die Entstehung des zeitlichen Verlaufs des Steuersignals eines pulsbreitenmodulierten Frequenzumformers für einen Dreiphasenasynchronmotor in Übermodulation,
- Figur 2b: das daraus entstehende Steuersignal für den Frequenzumformer,
- Figur 3a: eine Darstellung gemäß Figur 2a, jedoch in Untermodulation,
- Figur 3b: das zugehörige Steuersignal in Darstellung nach Figur 2b,

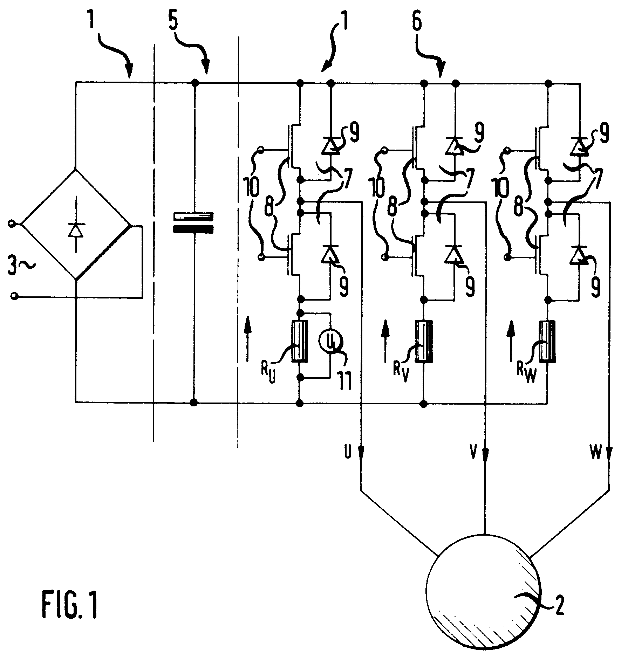

In Figur 1 ist der Frequenzumformer mit 1 gekennzeichnet, der davon gesteuerte Dreiphasenasynchronmotor mit 2. Gespeist wird der Frequenzumformer 1 in diesem Ausführungsbeispiel aus einem Einphasenwechselstromnetz 3. Der Frequenzumformer weist in an sich bekannter Weise den in Figur 1 dargestellten Leistungsteil bestehend aus Gleichrichter 4, Zwischenkreis 5 und Wechselrichter 6 sowie einem nicht dargestellten Steuer- und Regelkreis auf. Es spielt dabei keine Rolle, ob als Netz wie im vorliegenden Fall ein einphasiges oder aber ein dreiphasiges, also ein Drehstromnetz zur Verfügung steht, es muß lediglich der Gleichrichter 4 entsprechend ausgelegt sein.

Der Wechselrichter 6 besteht bei dem dargestellten Frequenzumformer für einen Dreiphasenasynchronmotor aus insgesamt sechs Zweigen 7 von denen jeder einen Schalter 8 sowie eine parallel geschaltete Diode 9 aufweist. Der Schalter 8 kann durch einen Transistor gebildet sein, für den Fall, daß ein MOS-FET-Transistor eingesetzt wird, kann die Diode 9 bekanntermaßen entfallen. Die Steueranschlüsse der Schalter 8 sind mit 10 gekennzeichnet.

Für jede Phase U, V, W des Motors 2 sind zwei Umrichterzweige 7 zuständig, die so gesteuert sind, daß immer ein Zweig 7 stromführend ist, wenn der andere nicht stromführend ist. Jeder Phase U, V, W ist also ein Zweigpaar zugeordnet, von denen jeweils der in Figur 1 untere Zweig der Niederspannungsseite und der andere (obere) Zweig 7 der Hochspannungsseite zugeordnet ist. Das Messen der Ströme auf der Niederspannungsseite hat den Vorteil, daß man vom gleichen Ausgangspotential wie im Steuerkreis ausgeht und dadurch eine vergleichsweise genaue Messung und einfache Auswertung erreicht. Der Strom wird dabei durch Messung des Spannungsabfalls an den Meßwiderständen R_{U}, R_{V} und R_{W} auf der Niederspannungsseite in den Leitungsführungen zu den Schaltern 8 und den Dioden 9 gemessen und ermittelt. Diese Widerstände und die daran anzuschließenden Spannungsmesser benötigen aufgrund ihrer Anordnung im Niederspannungsteil eine vergleichsweise einfache Isolierung. Die Widerstände und die daran anzuschließenden Spannungsmesser, beispielsweise in Form von Differenzverstärkern, ergeben aufgrund ihrer Anordnung eine einfache und günstige Signalverarbeitung. Ein solcher Spannungsmesser ist parallel zum Widerstand R_{U} beispielhaft eingezeichnet und mit 11 beziffert. Soweit zum reinen Meßaufbau.

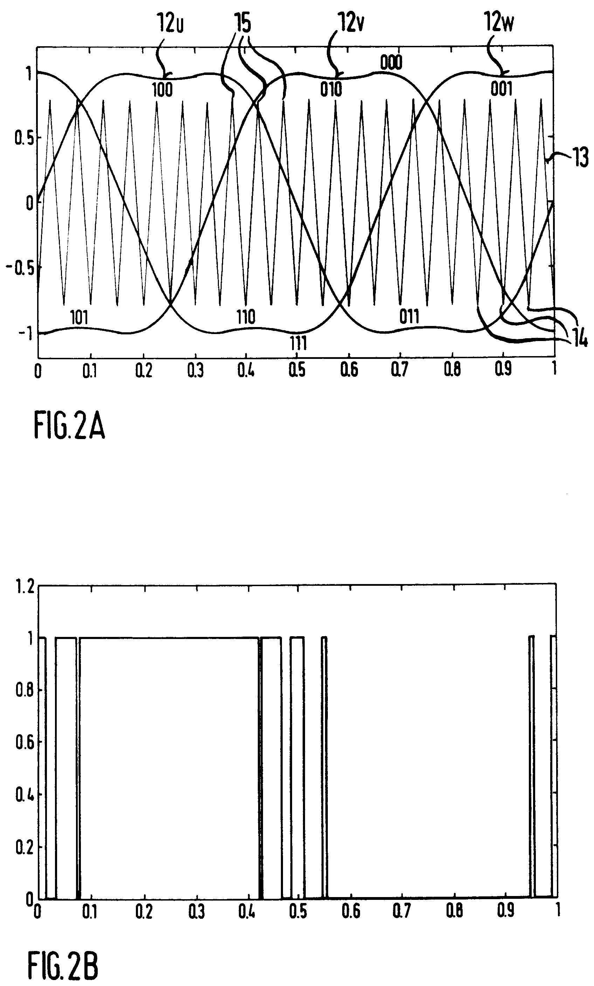

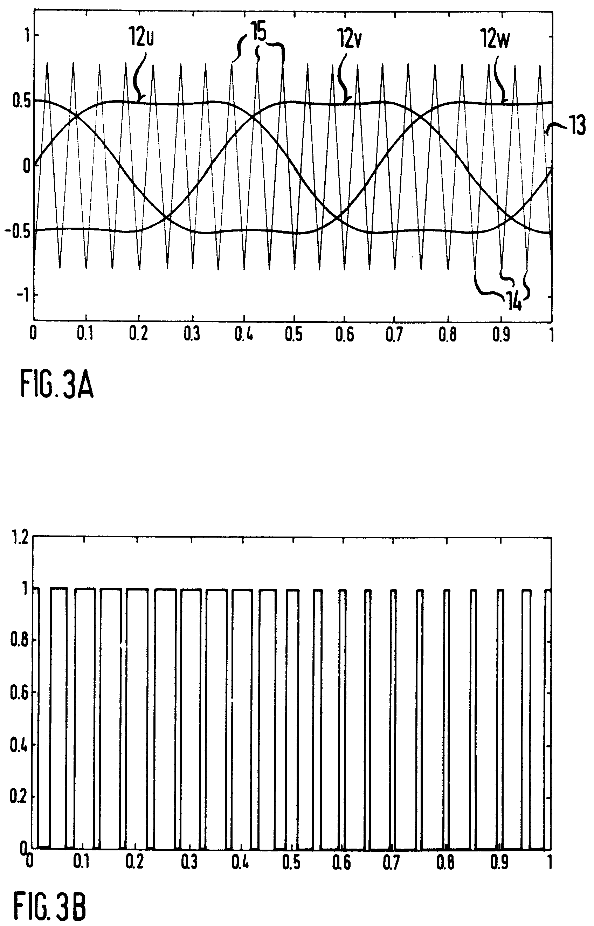

Die Figuren 2a und 3a zeigen, wie die Schalter 8 einer Seite des Wechselrichters 6, hier der Niederspannungsseite, durch den Steuerkreis angesteuert werden, bzw. wie diese Steuersignale gewonnen werden. Die Figuren 2b und 3b zeigen die sich daraus ergebenden Steuersignale beispielhaft jeweils für den auf der Niederspannungsseite angeordneten Schalter 8 für die Motorphase U.

Bei der Pulsbreitenmodulation muß innerhalb des Wechselrichters 6 sowohl eine Änderung der Spannung als auch eine Änderung der Frequenz erfolgen, da der Wechselstromwiderstand des Motors bekanntlich mit wachsender Frequenz zunimmt. Der Effektivwert der Motorspannung wird durch die Einschaltzeit bestimmt. Das anhand der Figuren 2b und 3b beispielhaft dargestellte Steuersignal wird durch drei, jeweils einer Motorphase zugeordnete Modulationskurven 12_{U}, 12_{V} und 12_{W} sowie ein damit überlagertes Trägersignal 13, in Form eines Dreiecksignals 13, gewonnen. Dabei bestimmen die Modulationskurven 12 die Grundfrequenz und die Trägerkurve 13 die Spannung, d.h. die Einschaltzeit. Das Modulationssignal 12 wird dem Trägersignal 13 überlagert, wobei der Schalter 8 stets dann öffnend angesteuert ist, wenn das der jeweiligen Phase und somit diesem Schalter zugeordnete Modulationssignal (beispielsweise 12_{U}) größer als das Trägersignal 13 ist.

Das Modulationssignal 12 besteht entsprechend den drei Motorphasen aus drei um 120° versetzt laufenden Modulationskurven 12_{U}, 12_{V} und 12_{W}. Jede Modulationskurve ist durch Überlagerung eines Sinussignals mit einer harmonischen Schwingung gebildet. Damit der Effektivwert der Phasenspannung auf einem höheren Niveau und damit die Schnittpunkte der Modulationskurven 12_{U}, 12_{V} und 12_{W} ebenfalls höher zu liegen kommen, was sowohl für Leistungsfähigkeit des Frequenzumformers als auch für die Messung von Vorteil ist.

Das Dreieck- und Trägersignal 13 weist im Falle der Übermodulation (Figur 2) stets eine geringere Amplitude als das Modulationssignal 12 auf, im Falle der Untermodulation (Figur 3) ist dies genau umgekehrt. Anhand der Figuren 2a bzw. 3a ist die Ermittlung des Steuersignals für die Bildung der Phasenströme, also für die Ansteuerung der Schalter 8, dargestellt.

Die Erfindung ist anhand eines Dreiphasenasynchronmotors dargestellt, es versteht sich, daß sie in analoger Weise auch an einem Elektromotor anderer Phasenzahl anwendbar ist.

Zur Vereinfachung des Meßaufbaus werden stets nur Ströme auf einer Seite des Wechselrichters 6 gemessen. Um beim Dreiphasenasynchronmotor die innerhalb des Umformers 1 zu einer Seite des Wechselrichters 6 fließenden Ströme exakt bestimmen zu können, ist es erforderlich, mindestens zwei der insgesamt drei Teilströme zu kennen, um so den dritten Teilstrom zumindest rechnerisch ermittelt zu können - die Summe der Phasenströme ist stets Null -. Da die Schalter 8 vom Steuer- und Regelkreis gesteuert werden, ist es möglich, anhand der vom Steuer- und Regelkreis abgegebenen Signale zu ermitteln, wann der vorerwähnte Zustand, in dem mindestens zwei Phasen zu einer Seite des Wechselrichters 6 stromführend sind, erreicht ist.

Vereinfacht kann dies jedoch dadurch werden, daß in bestimmten, zuvor festgelegten Punkten gemessen wird. Ein bevorzugter Meßzeitpunkt ist dann gegeben, wenn das Trägersignal 13 seinen unteren Wendepunkt 14 erreicht hat, da dann einerseits genügend Zeit zur Strommessung zur Verfügung steht und andererseits auch bei der Übermodulation gewährleistet ist, daß mindestens zwei Zweige 7 zu einer Seite des Umrichters 6 stromführend sind, wobei im Falle der Übermodulation weiterhin die Bedingung erfüllt sein muß, daß die Schnittpunkte der Modulationskurven 12_{U}, 12_{V} und 12_{W} innerhalb des durch die Wendepunkte 14 und 15 (obere Wendepunkte) des Trägersignals 13 begrenzten Bereiches liegen. Bei der Untermodulation spielt dies keine Rolle, da die unteren Wendepunkte 14 des Tragersignals 13 dann stets in einem Bereich liegen, in dem stets drei Zweige 7 einer Seite stromführend sind. Ein weiter bevorzugter Meßzeitpunkt liegt jeweils im Nulldurchgang des Trägersignals 13.

Zur Erläuterung sind in Figur 2a die Schaltzustände der einzelnen Umrichterzweige 7 zu einer Seite des Umrichters 6 in Form einer dreistelligen Binärzahl dargestellt, wobei die erste Zahl den Schaltzustand des der Phase U zugeordneten Zweigstromes, die zweite des der Phase V zugeordneten Zweigstromes und die dritte des der Phase W zugeordneten Zweigstromes darstellt und mit 1 der Stromfluß und mit 0 der nicht vorhandene Stromfluß gekennzeichnet ist.

Die Erfindung ist vorstehend beispielhaft anhand einer Messung erläutert, welche die Rekonstruktion des zeitlichen phasenbezogenen Motorstroms ermöglicht. Es versteht sich, daß anhand dieses Motorstroms zahlreiche andere elektrische Großen des Motors exakt bestimmbar sind, wie beispielsweise der cos φ. Dies kann beispielsweise zur Überwachung des Frequenzumformers ausgenutzt werden, so daß bei Überschreiten eines bestimmten cos φ schaltungstechnische Maßnahmen ausgelöst werden, die den Frequenzumformer vor seiner Zerstörung schützen.

### Bezugszeichenliste

- 1: - Frequenzumformer
- 2: - Motor
- 3: - Netz
- 4: - Gleichrichter
- 5: - Zwischenkreis
- 6: - Wechselrichter
- 7: - Umrichterzweig
- 8: - Schalter
- 9: - Diode
- 10: - Steueranschluß
- U, V, W: - Phasen
- R_{U}: - Meßwiderstand
- R_{V}: - Meßwiderstand
- R_{W}: - Meßwiderstand
- 11: - Spannungsmesser
- 12: - Modulationssignal
- 13: - Trägersignal
- 14: - untere Wendepunkte von 13
- 15: - obere Wendepunkte von 13

## Patentansprüche

1. Verfahren zur Messung elektrischer Größen, insbesondere des Stromes, an einem frequenzumformergesteuerten Elektromotor (2), dadurch gekennzeichnet, daß die Messung innerhalb eines stromführenden Umrichterzweigs (7) des Wechselrichters (6) des Frequenzumformers (1) erfolgt, und daß anhand dieser Messung die zu ermittelnde elektrische Größe des Motors bestimmt wird.

2. Verfahren nach Anspruch 1 zur Strommessung an einem Dreiphasenmotor, dadurch gekennzeichnet, daß die Ströme von mindestens zwei stromführenden Umrichterzweigen (7) einer Seite, vorzugsweise der Niederspannungsseite, des Wechselrichters (6) gleichzeitig gemessen werden und daraus alle Phasenströme ermittelt werden.

3. Verfahren nach Anspruch 1 zur Strommessung an einem Dreiphasenmotor, dadurch gekennzeichnet, daß die Strommessung in den Umrichterzweigen (7) zeitlich versetzt zueinander erfolgt und daß daraus ein Mittelwert errechnet wird.

4. Verfahren nach einem der vorhergehenden Ansprüche, bei dem das die Umrichterzweige (7) steuernde Signal innerhalb des Steuer- und Regelkreises des Frequenzumformers durch Überlagerung eines Modulationssignals (12) sowie eines Trägersignals (13) ermittelt wird, dadurch gekennzeichnet, daß die Strommessung stets dann erfolgt, wenn das Trägersignal (13) seinen unteren Wendepunkt (14) erreicht hat.

5. Verfahren nach einem der vorhergehenden Ansprüche, bei dem das die Umrichterzweige (7) steuernde Signal innerhalb des Steuer- und Regelkreises des Frequenzumformers durch Überlagerung eines Modulationssignals (12) sowie eines Trägersignals (13) ermittelt wird, dadurch gekennzeichnet, daß die Strommessung stets im Nulldurchgang des Trägersignals (13) erfolgt.

6. Einrichtung zur Messung elektrischer Größen an einem Elektromotor, der über einen Frequenzumformer angesteuert ist, wobei ein Phasenstrom durch Messung des Spannungsabfalls an einem Meßwiderstand (R_{U}, R_{V}, R_{W}) bestimmbar ist, dadurch gekennzeichnet, daß ein Meßwiderstand in den Frequenzumformer (1) integriert ist, und zwar innerhalb eines Umrichterzweigs (7) des Wechselrichters (6) des Frequenzumformers (1).

7. Einrichtung nach Anspruch 6, dadurch gekennzeichnet, daß ein Meßwiderstand (R_{U}, R_{V}, R_{W}) in der zu einem Schalter (8) des Wechselrichters (6) fuhrenden Leitung des Leistungsteils angeordnet ist.

8. Einrichtung nach Anspruch 6 oder 7, zur Messung der Phasenströme eines Dreiphasenmotors, dadurch gekennzeichnet, daß innerhalb des Wechselrichters drei Meßwiderstände (R_{U}, R_{V}, R_{W}) vorgesehen sind, die je einem Umrichterzweig (7) jeder Phase (U, V, W) zugeordnet sind.

9. Einrichtung nach einem der vorhergehenden Ansprüche, dadurch gekennzeichnet, daß alle Meßwiderstände (R_{U}, R_{V}, R_{W)} auf der Niederspannungsseite des Wechselrichters angeordnet sind.
